# EUROPÄISCHE PATENTANMELDUNG

(11) **EP 4 451 482 A1**
(43) Veröffentlichungstag der Anmeldung: **23.10.2024**
(21) Anmeldenummer: 24160428.9
(22) Anmeldetag: 29.02.2024
(51) Int. Cl.: H01R 13/52, H01R 13/66, H01R 13/533, H01R 13/405, H01R 13/74, H02G 3/08, H01R 12/71, H01R 31/06, H01R 43/24

(54) **VERBINDUNGSELEMENT UND SYSTEM MIT EINEM VERBINDUNGSELEMENT**

(30) Priorität: 21.04.2023 DE 102023110257
(71) Anmelder: SICK Engineering GmbH, 01458 Ottendorf-Okrilla (DE)
(72) Erfinder: Jehn, Robert, 01458 Ottendorf-Okrilla (DE); Walde, David, 01920 Steina (DE)
(74) Vertreter: Rieger, Daniel-Stephan

(57) **Zusammenfassung**

System (17) mit einem Verbindungselement (1) und Verbindungselement (1) zum elektrischen Verbinden einer ersten elektrischer Baugruppe (2) und einer zweiten elektrischen Baugruppe (3), wobei eine der Baugruppen (2, 3) in einem explosionsgeschützten Raum (4) liegt und das Verbindungselement (1) in einer Öffnung (5) zu dem explosionsgeschützten Raum (4) angeordnet ist und die Öffnung verschließt, wobei das Verbindungselement (1) eine zylinderförmige Hülse (6) aufweist, wobei die zylinderförmige Hülse (6) in einer Aufnahme der Öffnung (5) lösbar anordenbar ist, das Verbindungselement (1) in der zylinderförmigen Hülse (6) mindestens eine Leiterkarte (7) aufweist, wobei die Leiterkarte (7) eine Vielzahl von Leiterbahnen (8) zum elektrischen Verbinden der ersten elektrischen Baugruppe (2) und der zweiten elektrischen Baugruppe (3) aufweist, wobei das Verbindungselement (1) ein Vergussteil (9) aufweist, wobei die Leiterkarte (7) mittels des Vergussteiles (9) in der zylinderförmigen Hülse (6) fixiert und abgedichtet ist, wobei die jeweiligen Enden der Leiterkarte (7) mit den jeweiligen Leiterbahnen (8) aus dem Vergussteil (9) herausstehen.

## Beschreibung

Die vorliegende Erfindung betrifft ein Verbindungselement gemäß dem Oberbegriff von Anspruch 1 und ein System mit einem Verbindungselement gemäß dem Oberbegriff von Anspruch 12.

Der Explosionsschutz ist ein Teilgebiet der Technik, das sich mit dem Schutz vor der Entstehung von Explosionen und deren Auswirkungen beschäftigt. Er gehört zum Bereich der Sicherheitstechnik und dient der Verhütung von Schäden an Personen oder Sachen. Diese können ihre Ursache haben in menschlichem Fehlverhalten (Fehlbeurteilung bestehender Arbeitsbedingungen) oder defekten Arbeitsmittel, die wirksame Zündquellen des zu beurteilenden Systems darstellen. Der Explosionsschutz wird durch Umsetzung der integrierten Explosionssicherheit durch primäre, sekundäre und tertiäre Schutzziele erreicht. Sie umfassen zunächst Vermeidungsstrategien, die zum Beispiel durch Substitution die Entstehung explosionsfähiger Gemische vermeiden müssen. Nur wenn das nicht umsetzbar ist, greifen sekundär technische und auch ggf. auch organisatorische Maßnahmen, welche zum generellen Schutzziel haben, die Zündung auftretender explosionsfähiger Gemische unbedingt zu vermeiden. Erst wenn das technologisch nicht sicher verhindert werden kann, greift das tertiäre Schutzziel der Auswirkungsbegrenzung im Explosionsschutz (z. B. druckfeste Bauweise, Freiluftaufstellung mit Schutz- und ggf. auch Sicherheitsabständen).

Grundlage hierzu sind gesetzliche Bestimmungen wie zum Beispiel das EU-Gefahrstoffrecht, die Arbeitsmittelbenutzungsrichtlinie oder die ATEX-Richtlinien der Europäischen Union.

Die Zündschutzart ist eine Bezeichnung aus dem Explosionsschutz, die für verschiedene Konstruktionsprinzipien in diesem Bereich steht. Hinter jeder Zündschutzart steckt die Grundidee, das Risiko des gleichzeitigen Vorhandenseins einer explosionsfähigen Atmosphäre und von Zündquellen zu minimieren, bzw. die Ausbreitung einer Explosion zu verhindern. Beispielsweise darf es in einer Ex d druckfesten Kapsel zu einer Explosion kommen, der Flammdurchschlag nach außen wird aber verhindert.

Explosionen treten auf, wenn eine explosionsfähige Atmosphäre von einer Zündquelle gezündet wird. Um die Explosion zu verhindern, muss dafür gesorgt werden, dass nicht alle notwendigen Komponenten gleichzeitig auftreten. Während beim primären Explosionsschutz das Vorhandensein der explosionsfähigen Atmosphäre verhindert werden soll, ist beim sekundären Explosionsschutz die Vermeidung von Zündquellen das Ziel. Für die verschiedenen Arten, auf die die Zündquellen verhindert werden können, sind verschiedene Zündschutzarten definiert worden, die in verschiedenen internationalen und europäischen Normen beschrieben sind. Innerhalb der Richtlinien der Europäischen Gemeinschaft werden diese ebenfalls herangezogen.

Für die verschiedenen Anwendungen werden zum einen Zündschutzarten für Gas- und Staubatmosphäre und zum anderen für elektrische und mechanische Betriebsmittel unterschieden.

Als Zündschutzarten stehen für elektrische Betriebsmittel in Gas beispielsweise zur Verfügung: Eigensicherheit Ex i, Druckfeste Kapselung Ex d, Erhöhte Sicherheit Ex e, und Überdruckkapselung Ex p.

Derartige Verbindungselemente oder Systeme, die auch in explosionsgefährdeten Bereichen betrieben werden sollen, müssen daher sehr hohen Sicherheitsanforderungen hinsichtlich des Explosionsschutzes genügen. Dabei geht es im Besonderen darum, die Bildung von Funken sicher zu vermeiden oder zumindest sicherzustellen, dass ein im Fehlerfall entstandener Funke, keine Auswirkungen auf die Umgebung hat. Hierfür sind entsprechenden Normen in dazugehörigen Schutzklassen definiert. In der Schutzklasse mit dem Namen Eigensicherheit (Ex-i) wird der Explosionsschutz dadurch erzielt, dass die Werte für eine elektrischen Größe (Strom, Spannung, Leistung) zu jeder Zeit jeweils unterhalb eines jeweils vorgegebenen Grenzwertes liegen, damit auch im Fehlerfall kein Zündfunken erzeugt wird. In der weiteren Schutzklasse mit dem Namen Erhöhte Sicherheit (Ex-e) wird der Explosionsschutz dadurch erzielt, dass die räumlichen Abstände zwischen zwei verschiedenen elektrischen Potentialen so groß sind, dass eine Funkenbildung auch im Fehlerfall aufgrund der Distanz nicht auftreten kann. In der weiteren Schutzklasse mit dem Namen Druckfeste Kapselung (Ex-d) wird der Explosionsschutz dadurch erzielt, dass eine druckfeste Kapselung erfolgt. Bei der Zündschutzart Druckfeste Kapselung (Ex d), beruht die Funktionsweise auf dem Einschluss einer im Gehäuseinneren eventuell auftretenden Explosion. Erreicht wird dieses durch eine explosionsdruckfeste Auslegung des Gehäuses zusammen mit zünddurchschlagsicheren Spalten an allen Gehäuseöffnungen. Des Weiteren muss die Oberflächentemperatur auch bei Auftreten eines zu erwartenden Fehlers unter der Zündtemperatur der umgebenden explosionsfähigen Atmosphäre begrenzt werden. Die Anforderungen an ein Betriebsmittel dieser Zündschutzart sind in der Norm EN 60079-1 beschrieben. Diese Zündschutzart ist auch geeignet, wenn im Inneren des Betriebsmittels im ungestörten Betrieb Zündquellen auftreten.

Üblicherweise werden elektrische Signale über Durchführungen in EX d geschützte Räume ein- bzw. ausgeführt. Dies geschieht zum einen durch spezielle Kabelverschraubungen oder durch Aderleitungsdurchführungen.

Die Durchführung dieser elektrischen Signale in einen EX d geschützten Raum muss unter genormten Bedingungen erfolgen, um eine mögliche Explosion im EX d Raum nicht nach außen zu lassen. Dabei sind Zündspalte einzuhalten, um eine Flammenfront auf dem Weg nach draußen zum Erlöschen zu bringen und Materialien zu verwenden, welche auch nach Alterung nach Jahren die Schutzfunktion Druck und Widerstand gegen Bersten aufrechterhalten.

Klassisch werden Aderleitungsdurchführungen für diese Aufgabe eingesetzt. Sie bestehen aus einer Hülse, einer bestimmten variablen Anzahl sowie Art von Adern und einem Verguss, der sich zwischen den Adern und der Hülse befindet. Das gesamte System ist druckfest ausgeführt.

Die Nachteile der klassischen Aderleitungsdurchführung sind eine aufwändige Konfektionierung der Kabelenden auf beiden Seiten und die dadurch notwendige und langandauernde Verdrahtung der Kabel. Weiter nachteilig ist eine fehleranfällige Verdrahtung und der große Platzbedarf der Kabel. Aderleitungsdurchführungen sind teuer.

Das Patent US 9534939 B2 offenbart eine mehrteilige Leiterkartendurchführung, welche wieder in ihre Ausgangskomponenten zerlegt werden kann. Die Nachteile der mehrteiligen Leiterkartendurchführung sind, dass viele herzustellende Einzelteile mit hoher Genauigkeit notwendig sind. Die Einzelteile müssen nachweislich untereinander einen Zündspalt einhalten. Dadurch ist eine vollständige Maßprüfung aller Teile notwendig. Dadurch entstehen in Summe hohe Herstellkosten.

Weiter sind Vorrichtungen bekannt, bei der eine Leiterkarte in einem EX d Gehäuse fest vergossen ist. Diese ist nicht wechselbar und ein fester Bestandteil des Gehäuses.

Die Nachteile der im Gehäuse fest vergossen Variante sind, dass die Bestandteile, insbesondere die Leiterkarte, nicht wechselbar ist. Bei einem Defekt der Leiterkarte muss ein komplettes Gehäuseteil gewechselt werden. Die Lösung ist unflexibel, da diese nicht in anderen Gehäusen nutzbar ist und keine Variabilität bezüglich Art und Anzahl der Signale besteht.

Eine Aufgabe der Erfindung besteht darin, ein verbessertes Verbindungselement bereitzustellen.

Die Aufgabe wird gemäß Anspruch 1 gelöst durch ein Verbindungselement zum elektrischen Verbinden einer ersten elektrischen Baugruppe und einer zweiten elektrischen Baugruppe, wobei einer der Baugruppen in einem explosionsgeschützten Raum liegt und das Verbindungselement in einer Öffnung zu dem explosionsgeschützten Raum angeordnet ist und die Öffnung verschließt, wobei das Verbindungselement eine zylinderförmige Hülse aufweist, wobei die zylinderförmige Hülse in einer Aufnahme der Öffnung lösbar anordenbar ist, das Verbindungselement in der Hülse mindestens eine Leiterkarte aufweist, wobei die Leiterkarte eine Vielzahl von Leiterbahnen zum elektrischen Verbinden der ersten und zweiten elektrischen Baugruppen aufweist, wobei das Verbindungselement einen Vergussteil aufweist, wobei die Leiterkarte mittels des Vergussteiles in der Hülse fixiert und abgedichtet ist, wobei jeweilige Enden der Leiterkarte mit den jeweiligen Leiterbahnen aus dem Vergussteil herausstehen.

Die Aufgabe wird weiter gemäß Anspruch 12 gelöst durch ein System mit einem Verbindungselement zum elektrischen Verbinden einer ersten elektrischer Baugruppe und einer zweiten elektrischen Baugruppe, wobei einer der Baugruppen in einem explosionsgeschützten Raum liegt und das Verbindungselement in einer Öffnung zu dem explosionsgeschützten Raum angeordnet ist und die Öffnung verschließt, wobei das Verbindungselement eine zylinderförmige Hülse aufweist, wobei die zylinderförmige Hülse in einer Aufnahme der Öffnung lösbar anordenbar ist, das Verbindungselement in der Hülse mindestens eine Leiterkarte aufweist, wobei die Leiterkarte eine Vielzahl von Leiterbahnen zum elektrischen Verbinden der ersten und zweiten elektrischen Baugruppen aufweist, wobei das Verbindungselement einen Vergussteil aufweist, wobei die Leiterkarte mittels des Vergussteiles in der Hülse fixiert und abgedichtet ist, wobei jeweilige Enden der Leiterkarte mit den jeweiligen Leiterbahnen aus dem Vergussteil herausstehen.

Das Verbindungselement bzw. die Leiterkartendurchführung besteht aus der zylinderförmigen Hülse, dem Vergussteil und der mindestens einen Leiterkarte. Die Signale werden über die Leiterbahnen der mindestens einen Leiterkarte geführt.

Die Leiterkarte kann auch als Leiterplatte bezeichnet werden. Die Bezeichnungen Leiterkarte und Leiterplatte werden als synonyme Begriffe verwendet.

Es wird eine synergetische Lösung der Abdichtung durch die einzelnen Komponenten des Verbindungselements erreicht. Das Vergussteil mit einer Vergussmasse stellt den verklebten Zündspalt über die gesamte Lebensdauer des Verbindungselements sicher.

Gemäß der Erfindung ist eine deutliche Verringerung der Montagezeiten des Verbindungselements bzw. der Leiterkartendurchführung erreicht. Beispielsweise wird gegenüber einer Aderleitungsdurchführung mit beispielsweise 40 Einzeladern eine komplette Verdrahtungszeit von ca. einer Stunde eingespart. Weiter wird eine Vermeidung von Falschverdrahtungen vollständig vermieden.

Das Verbindungselement ist wesentlich günstiger als eine bestehende Aderleitungsdurchführung, da nur wenig Einzelkomponenten notwendig sind. Die Leiterkarte vereint eine Vielzahl von Leiterbahnen, die eine Vielzahl von Signalleitungen bilden. Beispielsweise sind mindestens 20, mindestens 40 oder mindestens 60 einzelne Leiterbahnen auf der Leiterkarte vorgesehen. Beispielsweise werden eigensichere oder nicht eigensichere Signale über die Leiterbahnen geführt. Durch die Vielzahl an Leiterbahnen können eine variable Übertragung in der Art und Anzahl der Signale bereitgestellt werden.

Durch die vorgesehene Leiterkarte und die relativ kurzen Überstände der Leiterkarte über das Vergussteil hinaus im Vergleich zu Aderleitungen wird kostbarer Bauraum vor und hinter der Leiterkartendurchführung in dem Vergussteil deutlich verringert, da kein Raum für Kabel und die Montage der Kabel vorgehalten werden muss.

Die Leiterkarte ist bevorzugt als starre Leiterkarte ausgebildet. Jedoch kann die Leiterkarte auch als flexible Leiterkarte ausgebildet sein. Beispielsweise ist die Leiterkarte als Flexboard bzw. Starrflex-Leiterkarte ausgebildet. Die Leiterkarte weist beispielsweise eine Dicke von ca. 1 mm bis 3 mm auf, insbesondere eine Dicke von 1,5 mm auf. Die Leiterkarte ist beispielsweise aus FR-4. FR-4 oder auch FR4 bezeichnet eine Klasse von schwer entflammbaren und flammenhemmenden Verbundwerkstoffen, bestehend aus Epoxidharz und Glasfasergewebe.

Vorteilhaft kann für das Verbindungselement eine Einzelteilzulassung für den Ex-d Bereich erfolgen. Damit kann das zugelassene Verbindungselement als zugelassene Komponente vorteilhaft in andere Leergehäuse eingesetzt werden. Der Zulassungsaufwand für weitere Geräte wird dadurch deutlich verringert.

Im Standardformat der Hülsendimension können Standard - EX d - Gehäuseöffnungen sowohl mit einer klassischen Aderleitungsdurchführung sowie auch mit dem erfindungsgemäßen Verbindungselement bestückt werden.

Bei der ersten elektrischen Baugruppe und der zweiten elektrischen Baugruppe, kann es sich auch um eine erste elektronische Baugruppe und eine zweite elektronische Baugruppe handeln. Die Bezeichnungen elektrische Baugruppe und elektronische Baugruppe sind hier als gleichwertig anzusehen.

Die zylinderförmige Hülse ist beispielsweise aus Aluminium hergestellt. Jedoch können auch andere korrosionsfreie Metalle zur Herstellung der zylinderförmigen Hülse verwendet werden. Beispielsweise kann die zylinderförmige Hülse aus Edelstahl gebildet sein. Die zylinderförmige Hülse kann jedoch auch aus Kunststoff hergestellt sein.

Das Vergussteil ist beispielsweise aus Polyurethan hergestellt. Polyurethane (Kurzzeichen PUR, teilweise auch PU) sind Kunststoffe oder Kunstharze, die aus der Polyadditionsreaktion von Dialkoholen (Diolen) beziehungsweise Polyolen mit Polyisocyanaten entstehen. Je nach Vernetzungsgrad und/oder eingesetzter Isocyanat- oder OH-Komponente erhält man Duroplaste oder Thermoplaste, die als Werkstoffe für das Vergussteil in Frage kommen.

Weitere beispielhafte Polyurethan basierte Vergussmassen, welche für das Vergussteil beispielsweise in Frage kommen sind:
PU-Vakuumgießharze: Verschiedene Produkte mit kurzer Topfzeit, die z. B. Serienmaterialien (Thermoplast-Spritzguss: ABS, PP, POM, PS, PC, PMMA etc.) ähnelnden mechanischen und thermischen Spezifikationen oder optischen Aspekten entsprechen. Sie werden in einer Vakuumgießanlage verarbeitet.
PU-Schnellgießharze: relativ einfach zu verarbeitende Produkte, die eine kurze Topfzeit besitzen und nicht unter Vakuum verarbeitet werden müssen.
Elastomer aushärtende PU-Gießharze: Produkte mit verschiedenen im Shore-A- und Shore-D-Bereich angesiedelten Härtegraden.
Elektrische Vergussmassen: zum Umgießen/Ummanteln von elektrischen und elektronischen Bauteilen (Potting) zum Zwecke der elektrischen Isolation und dem Schutz vor aggressiven Umgebungsbedingungen (chemisch, Temperatur, Vibrationen, mechanisch)

Als Vergussmaterial für das Vergussteil eignen sich beispielsweise weiter Silikon oder Epoxidharz.

Silikon (auch Silicone; Einzahl das Silikon oder Silicon), chemisch genauer Poly(organo)siloxane, ist eine Bezeichnung für eine Gruppe synthetischer Polymere, bei denen Siliciumatome über Sauerstoffatome verknüpft sind. Aufgrund ihres typisch anorganischen Gerüsts einerseits und der organischen Reste andererseits nehmen Silikone eine Zwischenstellung zwischen anorganischen und organischen Verbindungen ein, insbesondere zwischen Silikaten und organischen Polymeren. Sie sind in gewisser Weise Hybride und weisen ein einzigartiges Eigenschaftsspektrum auf, das von keinem anderen Kunststoff erreicht wird.

Als Epoxidharz oder abgekürzt EP-Harz bezeichnet man Kunstharze, die Epoxidgruppen tragen. Es handelt sich um Reaktionsharze, die nach Vermischung mit einem Härter zu einem duroplastischen Kunststoff reagieren. Der Härter ist dabei Reaktionspartner und bildet zusammen mit dem Harz einen makromolekularen Polyether mit in der Regel zwei endständigen Epoxidgruppen. Je nach Anwendung können Farb- und weitere Zusatzstoffe eingebunden werden. Nach der Aushärtung besitzen Epoxidharze gute mechanische Eigenschaften sowie eine gute Temperatur- und Chemikalienbeständigkeit
Das Verbindungselement hält beispielsweise einem Druck bis ca. 30 bar stand. Jedoch lassen sich auch Verbindungselemente herstellen, die einem höheren Druck standhalten.

In Weiterbildung der Erfindung sind die Enden der Leiterkarte für eine Steckeraufnahme ausgebildet.

An den Enden der Leiterkarte befinden sich beispielsweise freigelegte Leiterkontakte, welche in handelsübliche Steckverbinder gesteckt werden. Somit werden mehrere Leiterkontakte bzw. mehrere Signale gleichzeitig und verpolsicher gesteckt. Jedoch kann es auch vorgesehen sein, dass an den Enden der Leiterkarten jeweils ein Steckverbinder angeordnet bzw. angelötet ist, der mittels eines passenden Gegenstücks verbunden wird.

In Weiterbildung der Erfindung sind die Enden der Leiterkarte für eine Kabelanbindung ausgebildet. Beispielsweise sind die Enden der Leiterkarte als Lötkontakte ausgebildet.

Beispielsweise werden an die Enden der Leiterkarte Kabel angelötet, entweder direkt oder mit speziellen Crimp-Hülsen.

In Weiterbildung der Erfindung ist die zylinderförmige Hülse bzw. das Verbindungselement in der Öffnung eingesteckt. Beispielsweise wird eine formschlüssige Verbindung zwischen dem Rand der Öffnung und dem Verbindungselement bzw. der zylinderförmigen Hülse geschaffen. Hierzu weist die zylinderförmige Hülse beispielsweise einen Absatz bzw. einen Kragen auf, wodurch eine formschlüssige Verbindung zwischen dem Rand der Öffnung und dem Verbindungselement geschaffen ist. Jedoch kann die zylinderförmige Hülse auch noch einen Bajonett-Verschluss aufweisen, wodurch ebenfalls ein Formschluss gebildet ist.

In Weiterbildung der Erfindung ist die Hülse in der Öffnung eingeschraubt. Durch ein Gewinde auf der Außenseite der zylinderförmigen Hülse wird ebenfalls eine formschlüssige Verbindung zwischen dem Rand der Öffnung und dem Verbindungselement bzw. der zylinderförmigen Hülse geschaffen.

In Weiterbildung der Erfindung weist das Verbindungselement in der Hülse mehrere Leiterkarten auf. Die Leiterkartendurchführung nimmt mehrere Leiterkarten auf, um so die Kontaktanzahl zu erhöhen. Dadurch kann die Anzahl der Leiterbahnen erhöht werden. Weiter können auch stärkere bzw. breitere Leiterbahnen vorgesehen werden, um Stromsignale bzw. Energieversorgungsleitungen vorzusehen. Durch mehrere beabstandete Leiterkarten können auch die Abstände der Leiterbahnen erhöht werden. Insbesondere um Überschläge zwischen den Leiterbahnen zu vermeiden und notwendige Schutzabstände einzuhalten.

In Weiterbildung der Erfindung sind die Leiterkarten beabstandet und parallel angeordnet. Durch die parallele Anordnung der Leiterkarten ist eine besonders platzsparende Anordnung der Leiterkarten möglich. Insbesondere weisen benachbarte Leiterkarten jeweils geringere Breiten auf, je weiter diese außerhalb der Mitte der zylinderförmigen Hülse angeordnet sind.

In Weiterbildung der Erfindung weist die Hülse eine Druckplatte auf, wobei die Druckplatte innerhalb der Hülse angeordnet ist und die Druckplatte mindestens eine Öffnung für die Leiterkarte aufweist. Die Druckplatte ist im Querschnitt der zylinderförmigen Hülse angeordnet. Insbesondere liegt die Druckplatte an einem inneren Absatz der zylinderförmigen Hülse an, so dass die Druckplatte in der zylinderförmigen Hülse fixiert ist und sich an der zylinderförmigen Hülse abstützen kann. Dadurch kann die Druckplatte hohen Umgebungsdrücken standhalten.

Die Druckplatte ist beispielsweise aus Kunststoff oder Metall hergestellt. Beispielsweise ist die Druckplatte aus Duroplast oder Thermoplast hergestellt.

Die Druckplatte ist beispielsweise aus Aluminium hergestellt. Jedoch können auch andere korrosionsfreie Metalle zur Herstellung der Druckplatte verwendet werden. Beispielsweise kann die Druckplatte aus Edelstahl gebildet sein.

In Weiterbildung der Erfindung ist die Druckplatte an einem Ende der Hülse angeordnet und verschließt die Hülse im Querschnitt.

Die Druckplatte hält den Explosionsdruck von der Vergussmasse fern und vermeidet somit die Verformung des Vergussteils.

Die Herstellung erfolgt durch Zusammenstecken der Leiterkarten in die Druckplatte sowie der zylinderförmigen Hülse. Die Vergussmasse wird dann rückseitig offen eingebracht und härtet dann aus.

In Weiterbildung der Erfindung weist die Druckplatte Querflächen auf, wobei die Querflächen quer zur Druckplatte angeordnet sind und einstückig mit der Druckplatte verbunden sind. Durch die Querflächen bzw. Rippen wird die Stabilität der Druckplatte verbessert. Durch die Querflächen wird eine Verwindungssteifigkeit verbessert sowie die Verformung der Druckplatte bei beaufschlagtem Druck verbessert. Die Querflächen sind beispielsweise parallel und beabstandet zueinander angeordnet. Jedoch kann auch eine Gitterstruktur durch die Querflächen gebildet sein.

In Weiterbildung der Erfindung weist die Leiterkarte elektronische Schaltungen auf. Im Vergleich zur Aderleitungsdurchführung können auf der Leiterkarte kleine elektronische Schaltungen integriert werden. Insbesondere können elektronische Schaltungen beispielsweise zur Signalanpassung, zur Schutzbeschaltung, zur Signalentstörung und/oder zur Signalaufbereitung auf der Leiterkarte angeordnet werden.

Die Erfindung wird nachstehend auch hinsichtlich weiterer Vorteile und Merkmale unter Bezugnahme auf die beigefügte Zeichnung anhand von Ausführungsbeispielen erläutert.

Die Figuren der Zeichnung zeign in:

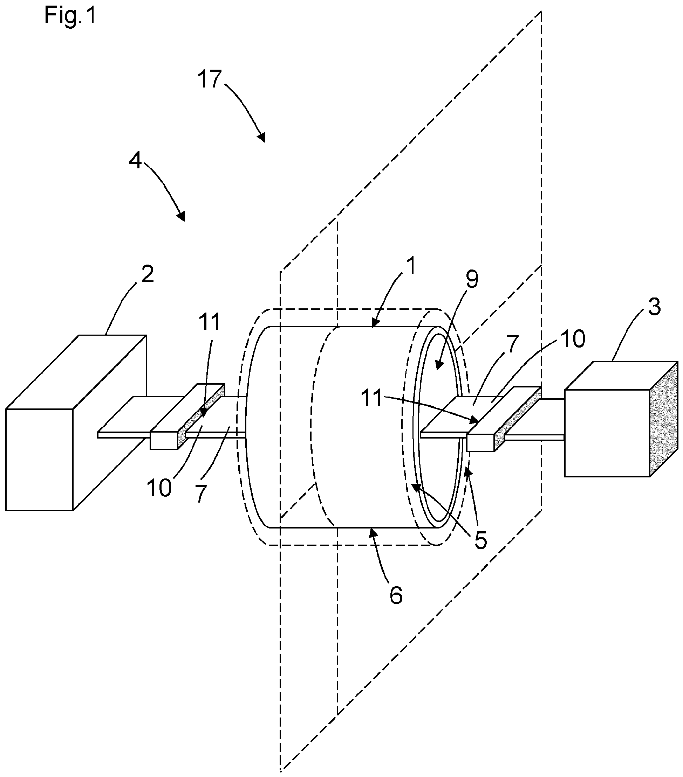

Figur 1 bis 8 jeweils ein Verbindungelement.

In den nachfolgenden Figuren sind identische Teile mit identischen Bezugszeichen versehen.

Figur 1 zeigt ein System 17 mit einem Verbindungselement 1 bzw. ein Verbindungselement 1 zum elektrischen Verbinden einer ersten elektrischer Baugruppe 2 und einer zweiten elektrischen Baugruppe 3, wobei eine der Baugruppen 2, 3 in einem explosionsgeschützten Raum 4 liegt und das Verbindungselement 1 in einer Öffnung zu dem explosionsgeschützten Raum 4 angeordnet ist und die Öffnung 5 verschließt, wobei das Verbindungselement 1 eine zylinderförmige Hülse 6 aufweist, wobei die zylinderförmige Hülse 6 in einer Aufnahme der Öffnung 5 lösbar anordenbar ist, das Verbindungselement 1 in der zylinderförmigen Hülse 6 mindestens eine Leiterkarte 7 aufweist, wobei die Leiterkarte 7 eine Vielzahl von Leiterbahnen zum elektrischen Verbinden der ersten elektrischen Baugruppe 2 und der zweiten elektrischen Baugruppe 3 aufweist, wobei das Verbindungselement 1 einen Vergussteil 9 aufweist, wobei die Leiterkarte 7 mittels des Vergussteiles 9 in der zylinderförmigen Hülse 6 fixiert und abgedichtet ist, wobei jeweilige Enden der Leiterkarte 7 mit den jeweiligen Leiterbahnen aus dem Vergussteil 9 herausstehen. Beispielsweise sind die Enden der Leiterkarte 7 für eine Steckeraufnahme 11 ausgebildet.

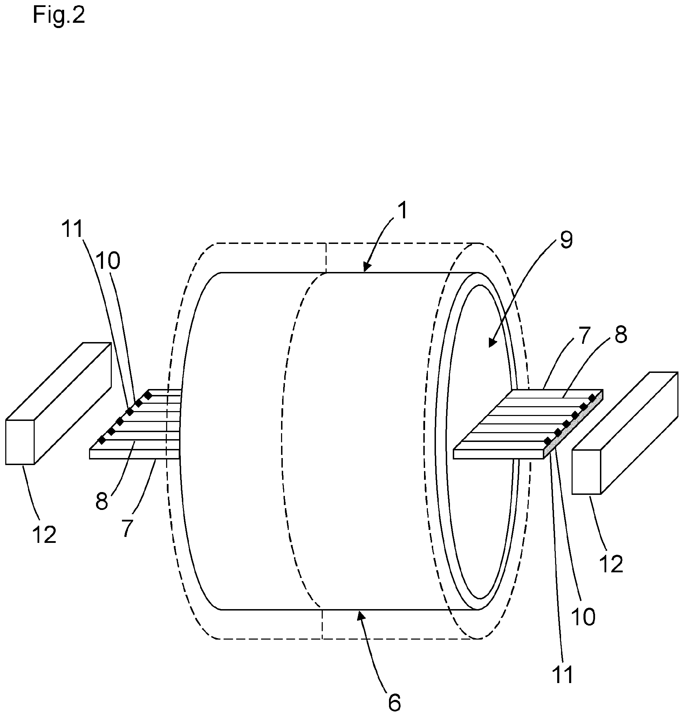

In Figur 2 ist das Verbindungselement 1 näher dargestellt. Das Verbindungselement 1 bzw. die Leiterkartendurchführung besteht mindestens aus der zylinderförmigen Hülse 6, dem Vergussteil 9 und der mindestens einen Leiterkarte 7. Die Signale werden über die Leiterbahnen 8 der mindestens einen Leiterkarte 7 geführt. An den Enden der Leiterkarte 7 befinden sich beispielsweise freigelegte Leiterkontakte, welche in handelsübliche Steckverbinder 12 gesteckt werden. Somit werden mehrere Leiterkontakte bzw. mehrere Signale gleichzeitig und verpolsicher gesteckt. Jedoch kann es auch vorgesehen sein, dass an den Enden 10 der Leiterkarte 7 jeweils ein Steckverbinder 12 angeordnet bzw. angelötet ist, der mittels einem passenden Gegenstück verbunden wird.

Die Leiterkarte 7 vereint eine Vielzahl von Leiterbahnen 8, die eine Vielzahl von Signalleitungen bilden. Beispielsweise sind mindestens 20, mindestens 40 oder mindestens 60 einzelne Leiterbahnen 8 auf der Leiterkarte 7 vorgesehen. Beispielsweise werden eigensichere oder nicht eigensichere Signale über die Leiterbahnen 8 geführt. Durch die Vielzahl an Leiterbahnen 8 ist eine variable Übertragung in der Art und Anzahl der Signale bereitgestellt.

Durch die vorgesehene Leiterkarte 7 und die relativ kurzen Überstände der Leiterkarte 7 über das Vergussteil 9 hinaus im Vergleich zu Aderleitungen wird kostbarer Bauraum vor und hinter der Leiterkartendurchführung in dem Vergussteil 9 deutlich verringert, da kein Raum für Kabel vorgehalten werden muss.

Die zylinderförmige Hülse 6 ist beispielsweise aus Aluminium hergestellt. Beispielsweise kann die zylinderförmige Hülse 6 aus Edelstahl gebildet sein. Die zylinderförmige Hülse 6 kann jedoch auch aus Kunststoff hergestellt sein. Bei der zylinderförmigen Hülse kann es sich beispielsweise um eine kreiszylinderförmige Hülse handeln.

Das Vergussteil 9 ist beispielsweise aus Polyurethan hergestellt. Als Vergussmaterial für das Vergussteil 9 eignen sich beispielsweise weiter Silikon oder Epoxidharz.

Das Verbindungselement 1 hält beispielsweise einem Druck bis ca. 30 bar stand. Jedoch lässt sich das Verbindungselement 1 auch herstellen, welches einem höheren Druck standhalten kann.

Die Außenkontur der zylinderförmigen Hülse 6 bildet den Zündspalt ab.

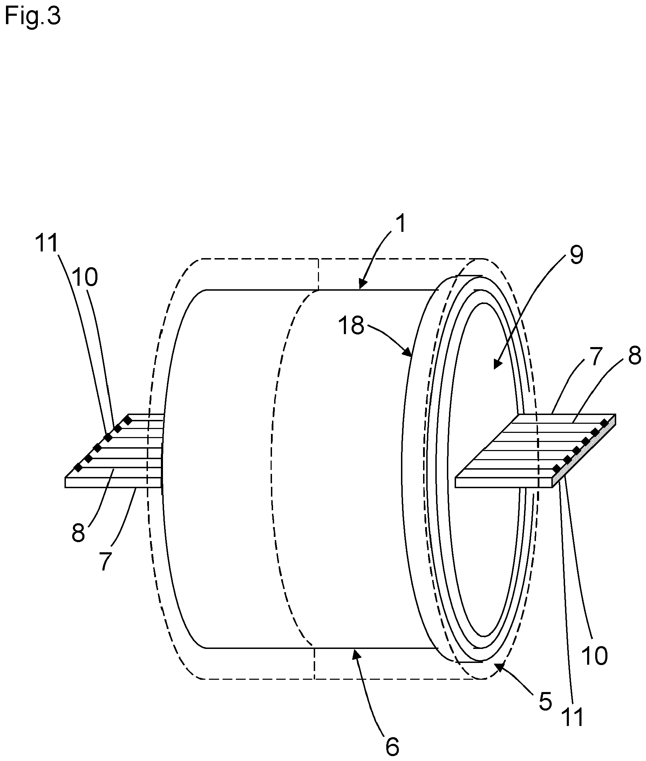

Gemäß Figur 3 ist die zylinderförmige Hülse 6 bzw. das Verbindungselement 1 in der Öffnung 5 eingesteckt. Beispielsweise wird eine formschlüssige Verbindung zwischen dem Rand der Öffnung 5 und dem Verbindungselement 1 bzw. der zylinderförmigen Hülse 6 geschaffen. Hierzu weist die zylinderförmige Hülse 6 beispielsweise einen Absatz 16 bzw. einen Kragen auf, wodurch eine formschlüssige Verbindung zwischen dem Rand der Öffnung 5 und dem Verbindungselement 1 geschaffen ist. Jedoch kann die zylinderförmige Hülse 6 auch einen Bajonett-Verschluss aufweisen, wodurch ebenfalls ein Formschluss gebildet ist.

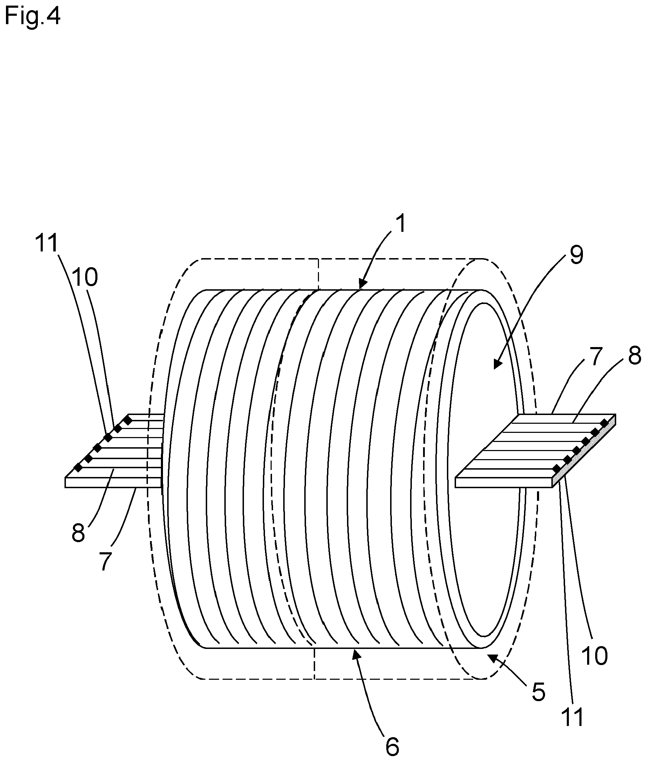

Beispielsweise ist die zylinderförmige Hülse 6 gemäß Figur 4 in der Öffnung 5 eingeschraubt. Durch ein Gewinde auf der Außenseite der zylinderförmigen Hülse 6 wird ebenfalls eine formschlüssige Verbindung zwischen dem Rand der Öffnung und dem Verbindungselement 1 bzw. der zylinderförmigen Hülse 6 geschaffen.

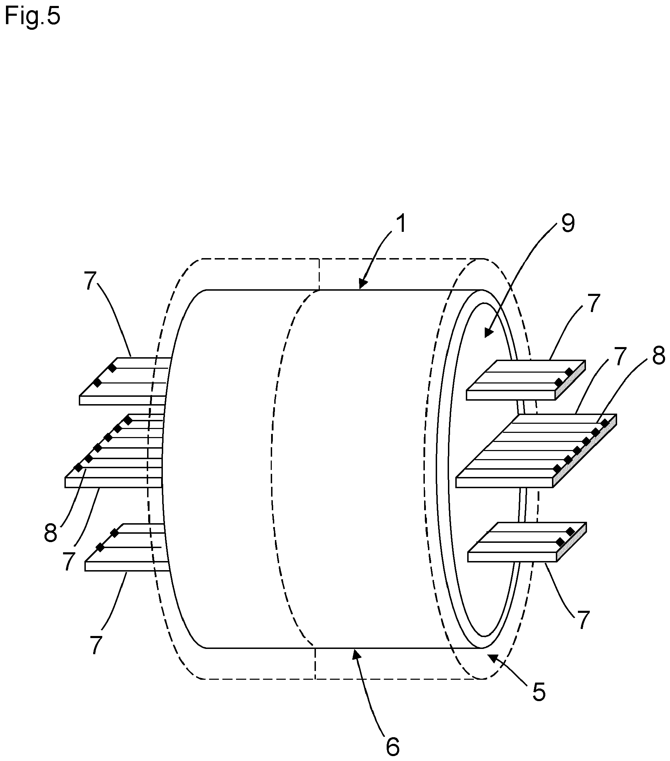

Beispielsweise weist das Verbindungselement 1 in der zylinderförmigen Hülse 6 gemäß Figur 5 mehrere Leiterkarten 7 auf. Die Leiterkartendurchführung nimmt mehrere Leiterkarten 7 auf, um so die Kontaktanzahl zu erhöhen. Dadurch kann die Anzahl der Leiterbahnen 8 erhöht werden. Weiter können auch stärkere bzw. breitere Leiterbahnen 8 vorgesehen werden, um Stromsignale bzw. Energieversorgungsleitungen vorzusehen. Durch mehrere beabstandete Leiterkarten 7 können auch die Abstände der Leiterbahnen 8 erhöht werden. Insbesondere um Überschläge zwischen den Leiterbahnen 8 zu vermeiden und notwendige Schutzabstände einzuhalten.

Beispielsweise sind die Leiterkarten 7 beabstandet und parallel angeordnet. Durch die parallele Anordnung der Leiterkarten 7 ist eine besonders platzsparende Anordnung der Leiterkarten 7 möglich. Beispielsweise weisen benachbarte Leiterkarten 7 jeweils geringere Breiten auf, je weiter diese außerhalb der Mitte der zylinderförmigen Hülse 6 angeordnet sind. Dies gilt beispeilsweise für den Teil der Leiterkarte in der Durchführung. Der Teil der Leiterkarte mit dem Steckerende kann dann wieder breiter sein oder auch gleich breit sein.

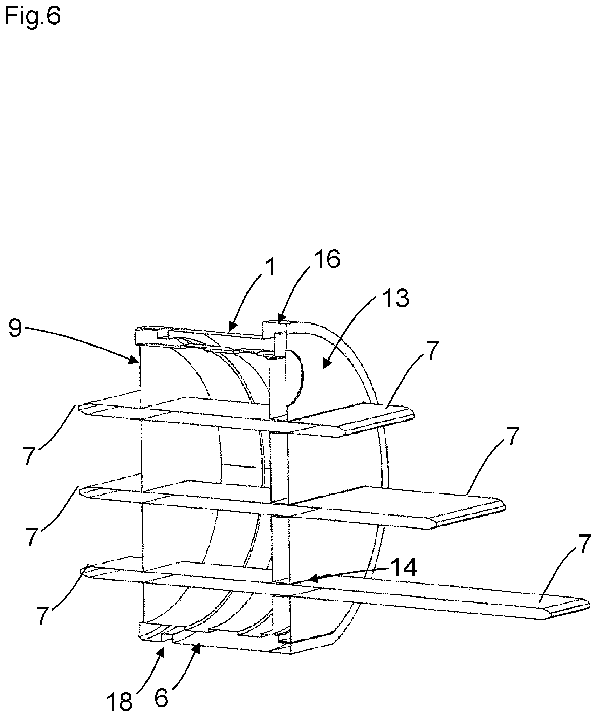

Gemäß Figur 6 ist das Verbindungselement 1 in einer Querschnittdarstellung dargestellt. Gemäß Figur 6 weist die zylinderförmige Hülse 6 eine Druckplatte 13 auf, wobei die Druckplatte 13 innerhalb der zylinderförmigen Hülse 6 angeordnet ist und die Druckplatte 13 mindestens eine Öffnung 14 für die Leiterkarte 7 aufweist. Die Druckplatte 13 ist im Querschnitt der zylinderförmigen Hülse 6 angeordnet. Insbesondere liegt die Druckplatte 13 an einem inneren Absatz der zylinderförmigen Hülse an, so dass die Druckplatte 13 in der zylinderförmigen Hülse 6 fixiert ist und sich an der zylinderförmigen Hülse 6 abstützen kann. Dadurch kann die Druckplatte 13 hohen Umgebungsdrücken standhalten. Weiter weist die zylinderförmige Hülse 6 beispielsweise eine umlaufende Nut 18 auf.

Die Druckplatte 13 ist beispielsweise aus Kunststoff oder Metall hergestellt. Beispielsweise ist die Druckplatte 13 aus Duroplast oder Thermoplast hergestellt.

Die Druckplatte 13 ist beispielsweise aus Aluminium hergestellt. Jedoch können auch andere korrosionsfreie Metalle zur Herstellung der Druckplatte 13 verwendet werden. Beispielsweise kann die Druckplatte 13 aus Edelstahl gebildet sein.

Gemäß Figur 6 ist die Druckplatte 13 an einem Ende der zylinderförmigen Hülse 6 angeordnet und verschließt die zylinderförmige Hülse 6 im Querschnitt.

Die Druckplatte 13 hält den Explosionsdruck von dem Vergussteil 9 bzw. der Vergussmasse fern und vermeidet somit die Verformung des Vergussteils 9.

Die Herstellung erfolgt beispielsweise durch Zusammenstecken der Leiterkarten 7 in die Druckplatte 13 sowie der zylinderförmigen Hülse 6. Die Vergussmasse wird dann beispielsweise rückseitig offen eingebracht und härtet dann zum Vergussteil 9 aus.

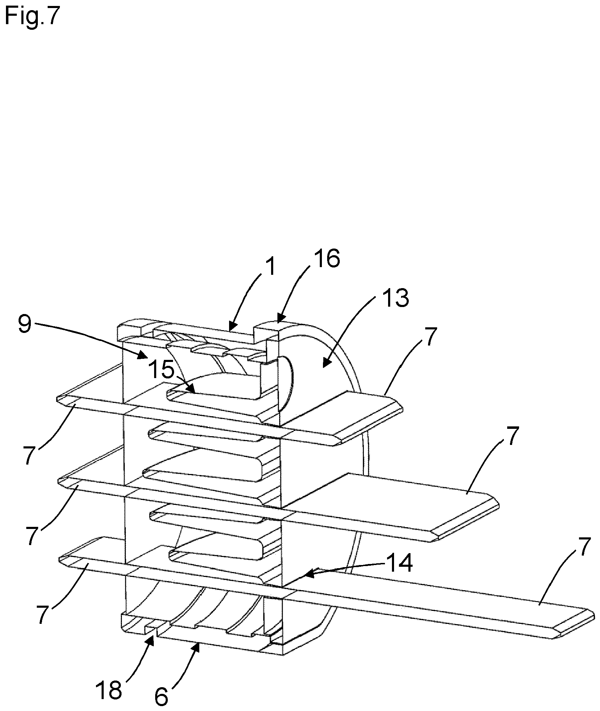

Gemäß Figur 7 weist die Druckplatte 13 Querflächen 15 auf, wobei die Querflächen 15 quer zur Druckplatte 13 angeordnet sind und einstückig mit der Druckplatte 13 verbunden sind. Durch die Querflächen 15 bzw. Rippen wird die Stabilität der Druckplatte 13 verbessert. Durch die Querflächen 15 wird eine Verwindungssteifigkeit verbessert sowie die Verformung der Druckplatte 13 bei beaufschlagtem Druck verbessert. Die Querflächen 15 sind beispielsweise parallel und beabstandet zueinander angeordnet. Jedoch kann auch eine Gitterstruktur durch die Querflächen 15 gebildet sein. Dabei sind einzelne Querflächen 15 quer zueinander und quer zur Druckplatte 13 angeordnet.

Beispielsweise weist die Leiterkarte 7 elektronische Schaltungen auf. Im Vergleich zur Aderleitungsdurchführung können auf der Leiterkarte 7 kleine elektronische Schaltungen integriert werden. Insbesondere können elektronische Schaltungen beispielsweise zur Signalanpassung, zur Schutzbeschaltung, zur Signalentstörung und/oder zur Signalaufbereitung auf der Leiterkarte 7 angeordnet werden.

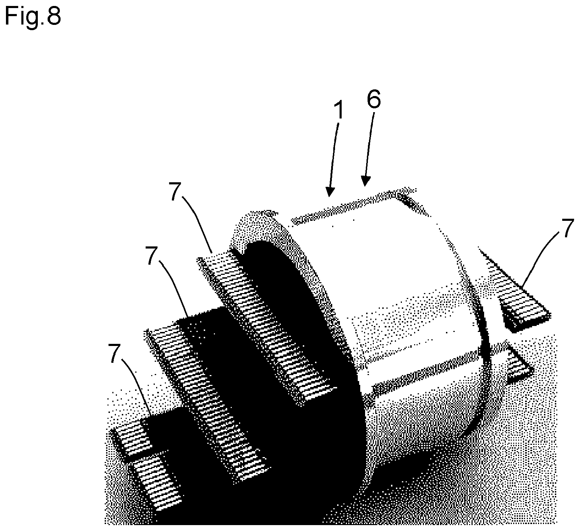

Beispielsweise weist das Verbindungselement 1 gemäß Figur 8 in der zylinderförmigen Hülse 6 mehrere Leiterkarten 7 auf. Beispielsweise sind die Leiterkarten 7 beabstandet und parallel angeordnet. Beispielsweise weisen benachbarte Leiterkarten 7 jeweils geringere Breiten auf, je weiter diese außerhalb der Mitte der zylinderförmigen Hülse 6 angeordnet sind. Dies gilt beispeilsweise für den Teil der Leiterkarte in der Durchführung. Der Teil der Leiterkarte mit dem Steckerende kann dann wieder breiter sein oder auch gleich breit sein. Die Signale werden über die Leiterbahnen der mindestens einen Leiterkarte 7 geführt. An den Enden der Leiterkarte 7 befinden sich beispielsweise freigelegte Leiterkontakte, welche in handelsübliche Steckverbinder 12 gesteckt werden.

### Bezugszeichen:

1 Verbindungselement
2 erste elektrische Baugruppe
3 zweite elektrische Baugruppe
4 explosionsgeschützter Raum
5 Öffnung
6 zylinderförmige Hülse
7 Leiterkarte
8 Leiterbahnen
9 Vergussteil
10 Enden der Leiterkarte
11 Steckeraufnahme
12 Stecker
13 Druckplatte
14 Öffnung für Leiterkarte
15 Querflächen der Druckplatte
16 Absatz
17 System
18 Nut

## Patentansprüche

1. Verbindungselement (1) zum elektrischen Verbinden einer ersten elektrischen Baugruppe (2) und einer zweiten elektrischen Baugruppe (3), wobei eine der Baugruppen (2, 3) in einem explosionsgeschützten Raum (4) liegt und das Verbindungselement (1) in einer Öffnung (5) zu dem explosionsgeschützten Raum (4) angeordnet ist und die Öffnung (5) verschließt,
**dadurch gekennzeichnet, dass**
das Verbindungselement (1) eine zylinderförmige Hülse (6) aufweist, wobei die zylinderförmige Hülse (6) in einer Aufnahme der Öffnung (5) lösbar anordenbar ist,
das Verbindungselement (1) in der zylinderförmigen Hülse (6) mindestens eine Leiterkarte (7) aufweist, wobei die Leiterkarte (7) eine Vielzahl von Leiterbahnen (8) zum elektrischen Verbinden der ersten elektrischen Baugruppe (2) und zweiten elektrischen Baugruppen (3) aufweist,
wobei das Verbindungselement (1) ein Vergussteil (9) aufweist,
wobei die Leiterkarte (7) mittels des Vergussteiles (9) in der Hülse (6) fixiert und abgedichtet ist,
wobei jeweilige Enden der Leiterkarte (7) mit den jeweiligen Leiterbahnen (8) aus dem Vergussteil (9) herausstehen.

2. Verbindungselement (1) nach Anspruch 1, **dadurch gekennzeichnet, dass** die Enden der Leiterkarte (7) für eine Steckeraufnahme (11) ausgebildet sind.

3. Verbindungselement (1) nach Anspruch 1, **dadurch gekennzeichnet, dass** die Enden der Leiterkarte (7) für eine Kabelanbindung ausgebildet sind.

4. Verbindungselement (1) nach Anspruch 1, **dadurch gekennzeichnet, dass** die zylinderförmige Hülse (6) in der Öffnung (5) eingesteckt ist.

5. Verbindungselement (1) nach Anspruch 1, **dadurch gekennzeichnet, dass** die zylinderförmige Hülse (6) in der Öffnung (5) eingeschraubt ist.

6. Verbindungselement (1) nach Anspruch 1, **dadurch gekennzeichnet, dass** das Verbindungselement (1) in der zylinderförmigen Hülse (6) mehrere Leiterkarten aufweist.

7. Verbindungselement (1) nach Anspruch 2, **dadurch gekennzeichnet, dass** die Leiterkarten (7) beabstandet und parallel angeordnet sind.

8. Verbindungselement (1) nach einem der vorhergehenden Ansprüche, **dadurch gekennzeichnet, dass** die zylinderförmige Hülse (6) eine Druckplatte (13) aufweist, wobei die Druckplatte (13) innerhalb der zylinderförmigen Hülse (6) angeordnet ist und die Druckplatte (13) mindestens eine Öffnung (14) für die Leiterkarte (7) aufweist.

9. Verbindungselement (1) nach einem der vorhergehenden Ansprüche, **dadurch gekennzeichnet, dass** die Druckplatte (13) an einem Ende der zylinderförmigen Hülse (6) angeordnet ist und die zylinderförmige Hülse (6) im Querschnitt verschließt.

10. Verbindungselement (1) nach einem der vorhergehenden Ansprüche, **dadurch gekennzeichnet, dass** die Druckplatte (13) Querflächen (15) aufweist, wobei die Querflächen (15) quer zur Druckplatte (13) angeordnet sind und einstückig mit der Druckplatte (13) verbunden sind.

11. Verbindungselement (1) nach einem der vorhergehenden Ansprüche, **dadurch gekennzeichnet, dass** die Leiterkarte (7) elektronische Schaltungen aufweist.

12. System (17) mit einem Verbindungselement (1) zum elektrischen Verbinden einer ersten elektrischer Baugruppe (2) und einer zweiten elektrischen Baugruppe (3), wobei eine der Baugruppen (2, 3) in einem explosionsgeschützten Raum (4) liegt und das Verbindungselement (1) in einer Öffnung (5) zu dem explosionsgeschützten Raum (4) angeordnet ist und die Öffnung verschließt,
**dadurch gekennzeichnet, dass**
das Verbindungselement (1) eine zylinderförmige Hülse (6) aufweist, wobei die zylinderförmige Hülse (6) in einer Aufnahme der Öffnung (5) lösbar anordenbar ist,
das Verbindungselement (1) in der zylinderförmigen Hülse (6) mindestens eine Leiterkarte (7) aufweist, wobei die Leiterkarte (7) eine Vielzahl von Leiterbahnen (8) zum elektrischen Verbinden der ersten elektrischen Baugruppe (2) und der zweiten elektrischen Baugruppe (3) aufweist,
wobei das Verbindungselement (1) ein Vergussteil (9) aufweist
wobei die Leiterkarte (7) mittels des Vergussteiles (9) in der zylinderförmigen Hülse (6) fixiert und abgedichtet ist,
wobei jeweilige Enden der Leiterkarte (7) mit den jeweiligen Leiterbahnen (8) aus dem Vergussteil (9) herausstehen
